# EUROPÄISCHE PATENTANMELDUNG

(11) **EP 3 404 699 A1**
(43) Veröffentlichungstag der Anmeldung: **21.11.2018**
(21) Anmeldenummer: 18180799.1
(22) Anmeldetag: 29.05.2013
(51) Int. Cl.: H01L 21/18

(54) **VORRICHTUNG UND VERFAHREN ZUM BONDEN VON SUBSTRATEN**

(62) Teilanmeldung aus: 13725967.7
(71) Anmelder: EV Group E. Thallner GmbH, 4782 St. Florian am Inn (AT)
(72) Erfinder: WAGENLEITNER, Thomas, 4971 Aurolzmünster (AT); WIMPLINGER, Markus, 4910 Ried im Innkreis (AT); Lindner, Friedrich Paul, 4780 Schärding (AT); Plach, Thomas, 4782 St. Florian am Inn (AT); KURZ, Florian, 4775 Taufkirchen/Pram (AT)
(74) Vertreter: Schneider, Sascha

(57) **Zusammenfassung**

Die vorliegende Erfindung betrifft ein Verfahren zum Bonden eines ersten Substrats (3) mit einem zweiten Substrat (8) an Kontaktflächen (3k, 8k) der Substrate (3, 8) mit folgenden Schritten, insbesondere folgendem Ablauf:
- Aufnahme des ersten Substrats (3) an einer ersten Aufnahmefläche (2o) einer ersten Aufnahmeeinrichtung (1) und Aufnahme des zweiten Substrats (8) an einer zweiten Aufnahmefläche (2o') einer zweiten Aufnahmeeinrichtung (4),
- Kontaktierung der Kontaktflächen (3k, 8k) an einer Bondinitiierungsstelle (20),
- Bonden des ersten Substrats (3) mit dem zweiten Substrat (8) entlang einer von der Bondinitiierungsstelle (20) zu Seitenrändern (3s, 8s) der Substrate (3, 8) verlaufenden Bondwelle,
dadurch gekennzeichnet, dass
das erste Substrat (3) und/oder das zweite Substrat (8) zur Ausrichtung der Kontaktflächen (3k, 8k) außerhalb der Bondinitiierungsstelle (20) vor und/oder während des Bondens verformt sind/werden.

Weiterhin betrifft die Erfindung eine korrespondierende Vorrichtung.

## Beschreibung

Die vorliegende Erfindung betrifft ein Verfahren zum Bonden eines ersten Substrats mit einem zweiten Substrat sowie eine korrespondierende Vorrichtung gemäß den nebengeordneten Ansprüchen.

Die voranschreitende Miniaturisierung in beinahe allen Teilen der Mikroelektronik und Mikrosystemtechnik sorgt für eine ständige Weiterentwicklung aller Technologien, mit deren Hilfe man die Dichte aller Arten von funktionalen Einheiten auf Substraten steigern kann. Zu diesen funktionalen Einheiten gehören beispielsweise Mikrocontroller, Speicherbausteine, MEMS, alle Arten von Sensoren oder Mikrofluidbauteile.

In den letzten Jahren wurden die Techniken zur Erhöhung der lateralen Dichte dieser funktionalen Einheiten stark verbessert. In einigen Teilbereichen der Mikroelektronik oder Mikrosystemtechnik sogar so weit, dass eine weitere Steigerung der lateralen Dichte der funktionalen Einheiten nicht mehr möglich ist. In der Mikrochipherstellung wurde die maximal erreichbare Auflösungsgrenze für die lithographisch herzustellenden Strukturen bereits so gut wie erreicht. Physikalische oder technologische Beschränkungen erlauben also in wenigen Jahren gar keine Steigerung der Problem bereits seit einigen Jahren durch die Entwicklung von 2.5D und 3D Technologien. Mit Hilfe dieser Technologien ist es möglich, gleiche, oder sogar unterschiedlich geartete, funktionale Einheiten zueinander auszurichten, übereinander zu stapeln, sie permanent miteinander zu verbinden und durch entsprechende Leiterbahnen miteinander zu vernetzen.

Eine der Schlüsseltechnologien für die Realisierung solcher Strukturen ist das Permanentbonden. Unter dem Permanentbonden versteht man alle Verfahren, mit deren Hilfe Substrate so miteinander verbunden werden können, dass deren Trennung nur durch hohen Energieaufwand und einer damit einhergehenden Zerstörung der Substrate möglich ist. Es existieren unterschiedliche Arten des Permanentbondens.

Eines der wichtigsten Permanentbondingverfahren ist das Fusionsbonden, auch bezeichnet als Direktbonden oder molekulares Bonden. Unter Fusionsbonden versteht man den Vorgang des permanenten Verbindens zweier Substrate über die Ausbildung kovalenter Verbindungen. Fusionsbonds entstehen vor allem an den Oberflächen von nichtmetallischnichtorganischen Materialien.

Grundsätzlich sollte zwischen einem Prebond und dem eigentlichen Permanentbond unterschieden werden. Unter einem Prebond versteht man eine sich bei Kontakt zweier Oberflächen spontan ausbildende Verbindung dieser Oberflächen deren Bindungsstärke kleiner ist als die Bindungsstärke des durch eine später durchgeführte Wärmebehandlung hergestellten, Permanentbonds. Die durch den Prebond hervorgerufene Bindungsstärke genügt allerdings, um die beiden Substrate zu transportieren, ohne eine Verschiebung der Substrate zueinander herbeizuführen. Obwohl also die Bindungsstärke zwischen den beiden Substraten sehr wohl ausreicht um den Substratstapel problemlos zu transportieren, ist die Bindungsstärke so gering, dass mit speziellen Vorrichtungen eine erneute, zerstörungsfreie Trennung der beiden Substrate erfolgen kann. Dies hat den entscheidenden Vorteil, dass nach einem Prebond, die Strukturen der beiden Strukturen vermessen und deren relative Positionen, Verzerrungen und Orientierungen bestimmt werden können. Stellt man während des Vermessungsvorgangs fest, dass eine Fehlorientierung und/oder eine lokale und/oder globale Verzerrung der Strukturen vorliegt oder sich Partikel im Interface befinden, kann der Substratstapel wieder entsprechend getrennt und neu prozessiert werden. Nach einem erfolgreichen und vor allem verifizierten Prebond wird durch Wärmebehandlungsprozesse ein Permanentbond erzeugt. Während des Wärmebehandlungsprozesses kommt es zu einer chemischen und/oder physikalischen Verstärkung der Verbindung der Oberflächen der beiden Substrate durch die Zufuhr der thermischen Energie. Dieser Permanentbond ist irreversibel in dem Sinne, dass eine zerstörungsfreie Trennung der beiden Substrate nicht mehr möglich ist. Im weiteren Verlauf wird nicht mehr explizit zwischen Prebond und Permanentbond unterschieden, sondern nur mehr allgemein von einem Bond gesprochen.

Die gängigsten Fusionsbonds werden an Silizium und Siliziumoxidsubstraten durchgeführt. Silizium dient durch seine Halbleitereigenschaften oft als Basismaterial für die Herstellung von mikroelektronischen Bauteilen wie Mikrochips und Speicher. Ein sogenannter Direktbond kann auch zwischen hochpolierten Metalloberflächen entstehen. Die zu Grunde liegenden Bindungseigenschaften unterschieden sich zwar von denen eines Fusionsbonds, der Mechanismus mit dem die beiden Oberflächen durch eine fortschreitende Bondwelle miteinander kontaktiert werden, kann aber durch dieselbe Physik beschrieben werden. Denkbar wäre auch die Verbindung zweier Hybridflächen durch einen sogenannten Hybridbond. Unter einer Hybridfläche versteht man eine aus mindestens zwei unterschiedlichen Materialien bestehende Oberfläche. Eines der beiden Materialien ist dabei meistens auf einen kleinen Raum begrenzt, während das zweite Material das erste Material umgibt. Beispielsweise werden Metallkontakte von Dielektrika umgeben. Bei der Erzeugung eines Hybridbonds durch das Bonden zweier Hybridoberflächen wird die Bondwelle vor allem durch den Fusionsbond zwischen den Dielektrika getrieben, während die Metallkontakte sich durch die Bondwelle automatisch zusammenfinden. Beispiele für Dielektrika und low-k Materialien sind
- Nicht Silizium basierend
   ∘ Polymere
      ▪ Polyimide
      ▪ Aromatische Polymere
      ▪ Parylene
      ▪ PTFE
   ∘ Amorpher Kohlenstoff
- Silizium basierend
   ∘ Silikat basierend
      ▪ TEOS (Tetraethylorthosilikat)
      ▪ SiOF
      ▪ SiOCH
      ▪ Gläser (Borosilikatgläser, Alumosilikatgläser, Bleisilikatgläser, Alkalisilikatgläser, etc.)
   ∘ Allgemein
      ▪ Si₃N₄
      ▪ SiC
      ▪ SiO₂
      ▪ SiCN
   ∘ Silsesquioxane
      ▪ HSSQ
      ▪ MSSQ

Eines der größten technischen Probleme beim permanenten Verbinden zweier Substrate stellt die Ausrichtungsgenauigkeit der funktionalen Einheiten zwischen den einzelnen Substraten dar. Obwohl die Substrate durch Ausrichtungsanlagen sehr genau zueinander ausgerichtet werden können, kann es während des Bondvorgangs selbst zu Verzerrungen der Substrate kommen. Durch die so entstehenden Verzerrungen werden die funktionalen Einheiten nicht notwendigerweise an allen Positionen korrekt zueinander ausgerichtet sein. Die Ausrichtungsungenauigkeit an einem bestimmten Punkt am Substrat kann ein Resultat einer Verzerrung, eines Skalierungsfehlers, eines Linsenfehlers (Vergrößerungs- bzw. Verkleinerungsfehlers) etc. sein. In der Halbleiterindustrie werden alle Themenbereiche, die sich mit derartigen Problemen befassen unter dem Begriff "Overlay" subsumiert. Eine entsprechende Einführung zu diesem Thema findet man beispielsweise in: Mack, Chris. Fundamental Principles of Optical Lithography - The Science of Microfabrication. WILEY, 2007, Reprint 2012*.*

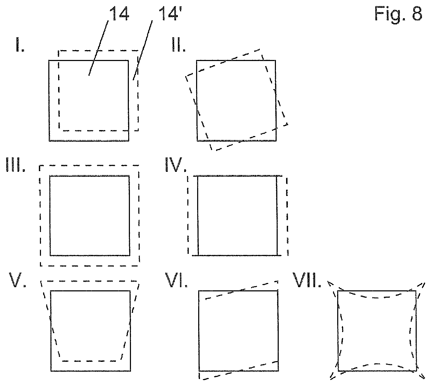

Jede funktionale Einheit wird vor dem eigentlichen Herstellprozess im Computer entworfen. Beispielsweise werden Leiterbahnen, Mikrochips, MEMS, oder jede andere mit Hilfe der Mikrosystemtechnik herstellbare Struktur, in einem CAD (engl.: computer aided design) Programm entworfen. Während der Herstellung der funktionalen Einheiten zeigt sich allerdings, dass es immer eine Abweichung zwischen den idealen, am Computer konstruierten, und den realen, im Reinraum produzierten, funktionalen Einheiten gibt. Die Unterschiede sind vorwiegend auf Limitierungen der Hardware, also ingenieurstechnische Probleme, sehr oft aber auf physikalische Grenzen, zurückzuführen. So ist die Auflösungsgenauigkeit einer Struktur, die durch einen photolithographischen Prozess hergestellt wird, durch die Größe der Aperturen der Photomaske und die Wellenlänge des verwendeten Lichts begrenzt. Maskenverzerrungen werden direkt in den Photoresist übertragen. Linearmotoren von Maschinen können nur innerhalb einer vorgegebenen Toleranz reproduzierbare Positionen anfahren, etc. Daher verwundert es nicht, dass die funktionalen Einheiten eines Substrats nicht exakt den am Computer konstruierten Strukturen gleichen können. Alle Substrate besitzen daher bereits vor dem Bondprozess eine nicht vernachlässigbare Abweichung vom Idealzustand.
Vergleicht man nun die Positionen und/oder Formen zweier gegenüberliegender funktionaler Einheiten zweier Substrate unter der Annahme, das keines der beiden Substrate durch einen Verbindungsvorgang verzerrt wird, so stellt man fest, dass im Allgemeinen bereits eine nicht perfekte Deckung der funktionalen Einheiten vorliegt, da diese durch die oben beschriebenen Fehler vom idealen Computermodell abweichen. Die häufigsten Fehler, werden in Figur 8 (*Nachgebildet von:* *http:*//*commons.wikimedia.org*/*wiki*/*File:Overlay_-*_*typical_model_terms_DE.svg, 24.05.2013 und* Mack, Chris. Fundamental Principles of Optical Lithography - The Science of Microfabrication. Chichester: WILEY, p. 312, 2007, Reprint 2012) dargestellt. Gemäß den Abbildungen kann man grob zwischen globalen und lokalen bzw. symmetrischen und asymmetrischen Overlayfehlern unterschieden. Ein globaler Overlayfehler ist homogen, daher unabhängig vom Ort. Er erzeugt die gleiche Abweichung zwischen zwei gegenüberliegenden funktionalen Einheiten unabhängig von der Position. Die klassischen globalen Overlayfehler sind die Fehler I. und II., welche durch eine Translation bzw. Rotation der beiden Substrate zueinander entstehen. Die Translation bzw. Rotation der beiden Substrate erzeugt einen dementsprechenden translatorischen bzw. rotatorischen Fehler für alle, jeweils gegenüberliegenden, funktionalen Einheiten auf den Substraten. Ein lokaler Overlayfehler entsteht ortsabhängig, vorwiegend durch Elastizitäts- und/oder Plastizitätsprobleme, im vorliegenden Fall vor allem hervorgerufen durch die sich kontinuierlich ausbreitende Bondwelle. Von den dargestellten Overlay Fehlern werden vor allem die Fehler III. und IV. als "run-out" Fehler bezeichnet. Dieser Fehler entsteht vor allem durch eine Verzerrung mindestens eines Substrats während eines Bondvorgangs. Durch die Verzerrung mindestens eines Substrats werden auch die funktionalen Einheiten des ersten Substrats in Bezug auf die funktionalen Einheiten des zweiten Substrats verzerrt. Die Fehler I. und II. können allerdings ebenfalls durch einen Bondprozess entstehen, werden allerdings von den Fehlern III-und IV. meistens so stark überlagert, dass sie nur schwer erkennbar bzw. messbar sind.

Im Stand der Technik existiert bereits eine Anlage, mit deren Hilfe man lokale Verzerrungen zumindest teilweise reduzieren kann. Es handelt sich dabei um eine lokale Entzerrung durch die Verwendung aktiver Steuerelemente (WO2012/083978A1).

Im Stand der Technik existieren erste Lösungsansätze zur Korrektur von "run-out"-Fehlern. Die US20120077329A1 beschreibt eine Methode, um eine gewünschte Ausrichtungsgenauigkeit zwischen den funktionalen Einheiten zweier Substrate während und nach dem Bonden zu erhalten, indem das untere Substrat nicht fixiert wird. Dadurch ist das untere Substrat keinen Randbedingungen unterworfen und kann während des Bondvorganges frei an das obere Substrat bonden. Ein wichtiges Merkmal im Stand der Technik stellt vor allem die flache Fixierung eines Substrats, meistens mittels einer Vakuumvorrichtung, dar.

Die entstehenden "run-out" Fehler werden in den meisten Fällen radialsymmetrisch um die Kontaktstelle stärker, nehmen daher von der Kontaktstelle zum Umfang zu. In den meisten Fällen handelt es sich um eine linear zunehmende Verstärkung der "run-out" Fehler. Unter speziellen Bedingungen können die "run-out" Fehler auch nichtlinear zunehmen.

Unter besonders optimalen Bedingungen können die "run-out" Fehler nicht nur durch entsprechende Messgeräte (EP2463892) ermittelt, sondern auch durch mathematische Funktionen beschrieben, werden. Da die "run-out" Fehler Translationen und/oder Rotationen und/oder Skalierungen zwischen wohldefinierten Punkten darstellen, werden sie mit Vorzug durch Vektorfunktionen beschrieben. Im Allgemeinen handelt es sich bei dieser Vektorfunktion um eine Funktion f:R²→R², daher um eine Abbildungsvorschrift, die den zweidimensionalen Definitionsbereich der Ortskoordinaten auf den zweidimensionalen Wertebereich von "run-out" Vektoren abbildet. Obwohl noch keine exakte mathematische Analyse der entsprechenden Vektorfelder vorgenommen werden konnte, werden Annahmen bezüglich der Funktionseigenschaften getätigt. Die Vektorfunktionen sind mit großer Wahrscheinlichkeit mindestens Cⁿ n>=1, Funktionen, daher mindestens einmal stetig differenzierbar. Da die "run-out" Fehler vom Kontaktierungspunkt zum Rand hin zunehmen, wird die Divergenz der Vektorfunktion wahrscheinlich von Null verschieden sein. Bei dem Vektorfeld handelt es sich daher mit großer Wahrscheinlichkeit um ein Quellenfeld.

Aufgabe der vorliegenden Erfindung ist es, eine Vorrichtung und ein Verfahren zum Bonden zweier Substrate vorzusehen, mit dem die Bondgenauigkeit, insbesondere am Rand der Substrate, erhöht wird.

Die vorliegende Aufgabe wird mit den Merkmalen der nebengeordneten Ansprüche gelöst. Vorteilhafte Weiterbildungen der Erfindung sind in den Unteransprüchen angegeben. In den Rahmen der Erfindung fallen auch sämtliche Kombinationen aus zumindest zwei in der Beschreibung, in den Ansprüchen und/oder den Zeichnungen angegebenen Merkmalen. Bei angegebenen Wertebereichen sollen auch innerhalb der genannten Grenzen liegende Werte als Grenzwerte offenbart gelten und in beliebiger Kombination beanspruchbar sein.

Die Erfindung betrifft ein Verfahren zum Bonden eines ersten Substrats (3) mit einem zweiten Substrat (8) an Kontaktflächen (3k, 8k) der Substrate (3, 8) mit folgenden Schritten, insbesondere folgendem Ablauf:
- Aufnahme des ersten Substrats (3) an einer ersten Aufnahmefläche (2o) einer ersten Aufnahmeeinrichtung (1) und Aufnahme des zweiten Substrats (8) an einer zweiten Aufnahmefläche (2o') einer zweiten Aufnahmeeinrichtung (4),
- Kontaktierung der Kontaktflächen (3k, 8k) an einer Bondinitiierungsstelle (20),
- Bonden des ersten Substrats (3) mit dem zweiten Substrat (8) entlang einer von der Bondinitiierungsstelle (20) zu Seitenrändern (3s, 8s) der Substrate (3, 8) verlaufenden Bondwelle,
wobei
das erste Substrat (3) und/oder das zweite Substrat (8) zur Ausrichtung der Kontaktflächen (3k, 8k) außerhalb der Bondinitiierungsstelle (20) vor und/oder während des Bondens verformt sind/werden.

Die Erfindung betrifft eine Vorrichtung zum Bonden eines ersten Substrats (3) mit einem zweiten Substrat (8) an Kontaktflächen (3k, 8k) der Substrate (3, 8) mit:
- einer ersten Aufnahmeeinrichtung (1) zur Aufnahme des ersten Substrats (3) an einer ersten Aufnahmefläche (2o) und einer zweiten Aufnahmeeinrichtung (4) zur Aufnahme des zweiten Substrats (8) an einer zweiten Aufnahmefläche (2o'),
- Kontaktmitteln zur Kontaktierung der Kontaktflächen (3k, 8k) an einer Bondinitiierungsstelle (20),
und mit
Verformungsmitteln zur Verformung des ersten Substrats (3) und/oder des zweiten Substrats (8) zur Ausrichtung der Kontaktflächen (3k, 8k) außerhalb der Bondinitiierungsstelle (20) vor und/oder während des Bondens.

Bevorzugt ist vorgesehen, dass die zweite Aufnahmeeinrichtung (4) eine Öffnung aufweist, und wobei die Öffnung mit einer Düse versehen ist zur Verformung des zweiten Substrats (8) durch Druckbeaufschlagung zur Ausrichtung der Kontaktflächen (3k, 8k).

Der Erfindung liegt der Gedanke zugrunde, dass mindestens eines der beiden Substrate, vorzugsweise das zweite und/oder untere Substrat zur Ausrichtung der Kontaktflächen, insbesondere ausschließlich, außerhalb der Bondinitiierungsstelle vor und/oder während des Bondens, insbesondere während des Laufs einer Bondwelle, vorzugsweise beim Fusionsbonden, verformt wird. Mit Verformung ist insbesondere ein von einem Ausgangszustand, insbesondere Ausgangsgeometrie, der Substrate abweichender Zustand gemeint. Erfindungsgemäß wird das Bonden nach einer Kontaktierung der Kontaktflächen insbesondere durch Fallenlassen/Loslösen des ersten/oberen Substrats, initiiert. Entsprechende Bondmittel sind vorrichtungsgemäß insbesondere vorgesehen.

Im Ausgangszustand sind die Substrate im Regelfall, insbesondere an einer Kontaktfläche, mehr oder weniger eben, abgesehen von etwaigen die Kontaktfläche überragenden Strukturen (Mikrochips, funktionale Bauteile) und Substrattoleranzen wie Biegung und/oder Dickenschwankungen. Die Substrate besitzen im Ausgangszustand aber in den meisten Fällen eine von Null verschiedene Krümmung. Für einen 300 mm Wafer sind Krümmungen von weniger als 50µm üblich. Mathematisch gesehen kann eine Krümmung als ein Maß für die lokale Abweichung einer Kurve von ihrem ebenen Zustand angesehen werden. Im konkreten Fall werden Substrate betrachtet, deren Dicken gering im Vergleich zum Durchmesser sind. Daher kann man in guter Näherung von der Krümmung einer Ebene sprechen. Im Fall einer Ebene ist der anfangs erwähnte, ebene Zustand die Tangentialebene der Kurve im Punkt, an welchem man die Krümmung betrachtet. Im Allgemeinen besitzt ein Körper, im speziellen Fall das Substrat, keine homogene Krümmung, so dass die Krümmung eine explizite Funktion des Ortes ist. So kann es beispielsweise sein, dass ein nicht ebenes Substrat im Zentrum eine konkave Krümmung, an anderen Stellen allerdings eine konvexe Krümmung aufweist. Im weiteren Verlauf werden Krümmungen im einfachsten Fall immer nur als konkav oder konvex beschrieben, ohne auf nähere mathematische Einzelheiten einzugehen, die Mathematikern, Physikern und Ingenieuren bekannt sind.

Ein, insbesondere eigenständiger, Kerngedanke für die meisten erfindungsgemäßen Ausführungsformen besteht vor allem darin, dass die Krümmungsradien der zwei miteinander zu verbondenden Substrate zumindest im Kontaktierungsbereich der Substrate, also an einer Bondfront der Bondwelle bzw. an der Bondlinie gleich sind, oder zumindest nur marginal voneinander abweichen. Die Differenz der beiden Krümmungsradien an der Bondfront/Bondlinie der Substrate ist dabei kleiner als 10m, mit Vorzug kleiner als 1m, mit größerem Vorzug kleiner als 1cm, mit größtem Vorzug kleiner als 1mm, mit allergrößtem Vorzug kleiner als 0.01mm, am bevorzugtesten kleiner als 1µm. Im Allgemeinen sind alle erfindungsgemäßen Ausführungsformen von Vorteil, welche den Krümmungsradius R1 minimieren. Mit anderen Worten: Die Erfindung betrifft eine Methode und eine Anlage, mit deren Hilfe man in der Lage ist, zwei Substrate so miteinander zu verbonden, dass deren lokale Ausrichtungsfehler, die man als "run-out" Fehler bezeichnet, minimal werden. Der Erfindung liegt dabei weiterhin der Gedanke zu Grunde, die beiden miteinander zu verbondenden Substrate, insbesondere durch geometrische, thermodynamische und/oder mechanische Kompensationsmechanismen, so zu steuern, dass die Einflussfaktoren auf die sich ausbildende Bondwelle so gewählt werden, dass die beiden Substrate sich während des Bondens lokal nicht zueinander verschieben, also richtig ausgerichtet sind. Des Weiteren beschreibt die Erfindung einen Artikel, bestehend aus zwei miteinander verbondeten Substraten mit erfindungsgemäß reduziertem "run-out" Fehler.

Ein erfindungsgemäß charakteristischer Vorgang beim Bonden, insbesondere Permanentbonden, vorzugsweise Fusionsbonden, ist die möglichst zentrische, punktförmige Kontaktierung der beiden Substrate. Im Allgemeinen kann die Kontaktierung der beiden Substrate auch nicht zentrisch erfolgen. Die sich von einem nicht-zentrischen Kontaktpunkt ausbreitende Bondwelle würde unterschiedliche Stellen des Substratrandes zu unterschiedlichen Zeiten erreichen. Entsprechend kompliziert wäre die vollständige mathematischphysikalische Beschreibung des Bondwellenverhaltens und der daraus resultierenden "run-out" Fehler Kompensation. Im Allgemeinen wird allerdings der Kontaktierungspunkt nicht weit vom Zentrum des Substrats entfernt liegen, sodass die sich daraus möglicherweise ergebenden Effekte, zumindest am Rand vernachlässigbar sind. Die Distanz zwischen einem möglichen nicht-zentrischen Kontaktierungspunkt und dem Zentrum des Substrats ist dabei kleiner als 100mm, mit Vorzug kleiner als 10mm, mit größerem Vorzug kleiner als 1mm, mit größtem Vorzug kleiner als 0.1mm, mit allergrößtem Vorzug kleiner als 0.01mm. Im weiteren Verlauf der Beschreibung soll unter Kontaktierung im Regelfall eine zentrische Kontaktierung gemeint sein. Unter Zentrum versteht man im weiteren Sinne mit Vorzug den geometrischen Mittelpunkt eines zugrundeliegenden, wenn nötig um Asymmetrien kompensierten, idealen Körpers. Bei industrieüblichen Wafern mit einem Notch ist das Zentrum also der Kreismittelpunkt des Kreises, der den idealen Wafer ohne notch, umgibt. Bei industrieüblichen Wafern mit einem Flat (abgeflachte Seite) ist das Zentrum der Kreismittelpunkt des Kreises, der den idealen Wafer ohne flat, umgibt. Analoge Überlegungen gelten für beliebig geformte Substrate. In speziellen Ausführungsformen kann es allerdings von Nutzen sein, unter dem Zentrum den Schwerpunkt des Substrats zu verstehen. Um eine exakte, zentrische, punktförmige Kontaktierung zu gewährleisten wird eine mit einer zentrischen Bohrung und einem darin translatorisch bewegbaren Stift versehene obere Aufnahmeeinrichtung (Substrathalter) mit einer radialsymmetrischer Fixierung versehen. Denkbar wäre auch die Verwendung einer Düse, welche ein Fluid, mit Vorzug ein Gas an Stelle des Stifts zur Druckbeaufschlagung verwendet. Des Weiteren kann sogar vollständig auf die Verwendung derartiger Elemente verzichtet werden, wenn man Vorrichtungen vorsieht, welche die beiden Substrate durch eine Translationsbewegung aneinander annähern können unter der weiteren Voraussetzung, dass mindestens eines der beiden Substrate, mit Vorzug das obere Substrat, auf Grund der Gravitation eine aufgeprägte Krümmung in Richtung des anderen Substrats besitzt, und daher bei der erwähnten translatorischen Annäherung, bei genügend geringem Abstand zum entsprechenden zweiten Substrat, automatisch kontaktiert.

Bei der radialsymmetrischen Fixierung handelt es sich entweder um angebrachte Vakuumlöcher, eine kreisrunde Vakuumlippe oder vergleichbare Vakuumelemente, mit deren Hilfe der obere Wafer fixiert werden kann. Denkbar ist auch die Verwendung einer elektrostatischen Aufnahmeeinrichtung. Der Stift in der zentrischen Bohrung des oberen Substrathalters dient der steuerbaren Durchbiegung des fixierten, oberen Substrats.

Nach der erfolgten Kontaktierung der Zentren beider Substrate wird die Fixierung des oberen Substrathalters gelöst. Das obere Substrat fällt einerseits durch die Schwerkraft und andererseits bedingt durch eine entlang der Bondwelle und zwischen den Substraten wirkende Bondkraft nach unten. Das obere Substrat wird radial vom Zentrum zum Seitenrand hin mit dem unteren Substrat verbunden. Es kommt so zu einer erfindungsgemäßen Ausbildung einer radialsymmetrischen Bondwelle, die insbesondere vom Zentrum zum Seitenrand verläuft. Während des Bondvorganges drücken die beiden Substrate das zwischen den Substraten vorliegende Gas, insbesondere Luft, vor der Bondwelle her und sorgen damit für eine Bondgrenzfläche ohne Gaseinschlüsse. Das obere Substrat liegt während des Fallens praktisch auf einer Art Gaspolster.

Das erste/obere Substrat unterliegt nach der Initiierung des Bonds an einer Bondinitiierungsstelle keiner zusätzlichen Fixierung, kann sich also abgesehen von der Fixierung an der Bondinitiierungsstelle frei bewegen und auch verzerren. Durch die erfindungsgemäß voranschreitende Bondwelle, die an der Bondwellenfront auftretenden Spannungszustände und die vorliegenden geometrischen Randbedingungen wird jedes bezüglich seiner radialen Dicke infinitesimal kleine Kreissegment einer Verzerrung unterliegen. Da die Substrate allerdings starre Körper darstellen, summieren sich die Verzerrungen als Funktion des Abstandes vom Zentrum her auf. Dies führt zu "run-out" Fehlern, die durch das erfindungsgemäße Verfahren und die erfindungsgemäße Vorrichtung beseitigt werden sollen.

Die Erfindung betrifft somit auch ein Verfahren und eine Vorrichtung, um den "run-out"-Fehler zwischen zwei gebondeten Substraten, insbesondere durch thermodynamische und/oder mechanische Kompensationsmechanismen, beim Bonden zu verringern oder sogar ganz zu vermeiden. Des Weiteren behandelt die Erfindung einen entsprechenden Artikel, der mit der erfindungsgemäßen Vorrichtung und dem erfindungsgemäßen Verfahren hergestellt wird.

In einer ersten Ausführungsform der Erfindung ist die erste, insbesondere untere, Aufnahmeeinrichtung an der Aufnahmefläche zur Aufnahme des ersten Substrats konvex oder konkav geschliffen und/oder poliert und/oder geläppt. Mit Vorzug ist die Aufnahmeeinrichtung konvex geschliffen, sodass ein darauf fixiertes Substrat in Richtung des Kontaktierungspunkt beziehungsweise der Bondinitiierungsstelle gekrümmt wird.

Ein Krümmungsradius der ersten und/oder zweiten Aufnahmeflächen ist insbesondere größer als 0,01m, mit Vorzug größer als 0,1m, mit größerem Vorzug größer als 1m, mit noch größerem Vorzug größer als 10m, mit allergrößtem Vorzug größer als 100m, am bevorzugtesten größer als 1000m. In einer besonderen Ausführungsform ist der Krümmungsradius der ersten/unteren Aufnahmeeinrichtung gleich groß, insbesondere zumindest innerhalb derselben Größenordnung einer Zehnerpotenz, wie der durch die zweite/oberen Aufnahmeeinrichtung durch Stellmittel, insbesondere einen Stift, erzeugte Krümmungsradius des zweiten/oberen Substrats. Dadurch kommt es zu einer bezüglich der Geometrie symmetrischen Ausgangsstellung für das Bonden.

Es ist von Vorteil, wenn die erste/untere Aufnahmefläche so geschliffen ist/sind, dass die physikalische Asymmetrie durch das normal auf die Aufnahmefläche wirkende, Gravitationsfeld dahingehend korrigiert wird, dass sich die Bondwellenfront immer innerhalb derselben, horizontalen Ebene bewegt.

Das erste und/oder zweite Substrat ist mit Vorzug radialsymmetrisch. Obwohl das Substrat jeden beliebigen Durchmesser besitzen kann, ist der Waferdurchmesser insbesondere 1 Zoll, 2 Zoll, 3 Zoll, 4 Zoll, 5 Zoll, 6 Zoll, 8 Zoll, 12, Zoll, 18 Zoll oder größer als 18 Zoll. Die Dicke des ersten und/oder zweiten Substrats liegt zwischen 1µm und 2000µm, mit Vorzug zwischen 10µm und 1500µm, mit größerem Vorzug zwischen 100µm und 1000µm.

In besonderen Ausführungsformen kann ein Substrat auch eine rechteckige, oder zumindest von der kreisförmigen Gestalt abweichende, Form besitzen. Unter einem Substrat wird im weiteren Verlauf insbesondere ein Wafer verstanden.

In einer zweiten Ausführungsform der unteren/ersten Aufnahmeeinrichtung ist der Krümmungsradius der unteren/ersten Aufnahmefläche einstellbar. In einer besonders einfach Ausführungsform besitzt die untere Aufnahmeeinrichtung eine Auflageplatte, die dick genug ist, um nicht durch ungewollte äußere Einflüsse verformt zu werden, allerdings dünn genug gefertigt wurde um durch eine gezielte, von unten wirkende Kraft in eine konvexe oder konkave Form gebracht zu werden. Insbesondere weist die Auflageplatte eine Biegesteifigkeit von größer 10⁻⁷ Nm², mit Vorzug größer als 10⁻³ Nm², mit größerem Vorzug größer 1 Nm², mit noch größerem Vorzug größer 10³ Nm², mit allergrößtem Vorzug größer 10⁷ Nm² auf.
Gemäß einer Ausführung der Erfindung besteht ein, insbesondere innenliegender, Teil der unteren/ersten Aufnahmeeinrichtung aus einer pneumatisch und/oder hydraulisch und/oder piezoelektrisch dehnbaren und/oder kontrahierbaren mit Vorzug hochfesten, elastischen Membran. Die pneumatischen und/oder hydraulischen und/oder piezoelektrischen Elemente sind dabei mit Vorzug gleichverteilt und einzeln ansteuerbar.

In einer weiteren, erfindungsgemäßen Ausführungsform wird die untere/erste Aufnahmeeinrichtung so ausgebildet, dass das untere/erste Substrat durch Heiz- und/oder Kühlmittel noch vor der Kontaktierung gezielt verformt, insbesondere lateral gestaucht oder gedehnt, wird, und zwar um den Betrag, der bei der späteren Kontaktierung notwendig ist, um den entstehenden "run-out" Fehler bestmöglich, im Idealfall vollständig, zu kompensieren. Da die Fixierung des unteren/ersten Substrats in dieser Ausführungsform erst nach der entsprechenden Verformung erfolgt, muss man keinen besonderen Wert auf die thermischen Ausdehnungskoeffizienten des unteren/ersten Substrats bzw. der unteren/ersten Aufnahmeeinrichtung legen.

In einer weiteren besonderen, erfindungsgemäßen Vorgehensweise erfolgt die Kontaktierung des unteren/ersten Substrats vor einem Heiz- und/oder Kühlvorgang. Durch die Fixierung vor dem Heiz- und/oder Kühlvorgang folgt das untere/erste Substrat der thermischen Dehnung der unteren/ersten Aufnahmeeinrichtung, sodass deren thermischer Ausdehnungskoeffizient genutzt werden kann, um die (thermische) Dehnung des Substrats vorzugeben. Mit Besonderem Vorzug sind die thermischen Ausdehnungskoeffizienten des unteren/ersten Substrats und der unteren/ersten Aufnahmeeinrichtung gleich, sodass beim Heiz- und/oder Kühlvorgang keine oder zumindest geringe thermische Spannungen im unteren/ersten Substrat entstehen. Erfindungsgemäß denkbar wäre es auch, dass die thermischen Ausdehnungskoeffizienten unterschiedlich sind. Im Falle unterschiedlicher thermischer Ausdehnungskoeffizienten wird das untere/erste Substrat im Mittel der thermischen Dehnung der unteren/ersten Aufnahmeeinrichtung folgen.

Die einzustellenden Temperaturdifferenzen zwischen der ersten und zweiten Aufnahmeeinrichtung betragen dabei weniger als 20°C, mit Vorzug wenig als 10°C, mit größerem Vorzug weniger als 5°C, mit größtem Vorzug weniger als 2°C, mit allergrößtem Vorzug weniger als 1°C. Jede Aufnahmeeinrichtung wird erfindungsgemäß möglichst homogen durchwärmt. Insbesondere ist ein Temperaturfeld vorgesehen, dessen Temperaturdifferenz an zwei beliebigen Punkten kleiner als 5°C ist, mit Vorzug kleiner als 3°C, mit größerem Vorzug kleiner als 1°C, mit größtem Vorzug kleiner als 0.1°C, mit allergrößtem Vorzug kleiner als 0.05°C ist.

In einer weiteren, erfindungsgemäßen Ausführungsform wird die erste Aufnahmeeinrichtung so konstruiert, dass die Aufnahmeeinrichtung an der Aufnahmefläche gezielt durch mechanische Stellmittel verformt, insbesondere gestaucht und/oder gedehnt, werden kann. Das auf der Oberfläche der ersten Aufnahmeeinrichtung fixierte erste Substrat wird auf Grund seiner in Bezug auf die Aufnahmeeinrichtung geringen Dicke durch die Verformung der Aufnahmeeinrichtung mit verformt. Die Verformung der Aufnahmeeinrichtung erfolgt dabei mit pneumatischen und/oder hydraulischen und/oder piezoelektrischen Aktuatoren, die, mit Vorzug radialsymmetrisch, um die Substrataufnahme verteilt angeordnet worden sind. Für eine vollständig symmetrische, rein radiale Verzerrung benötigt man mindestens drei Aktuatoren, die zueinander in einem Winkelabstand von 120° angeordnet sind. Mit Vorzug werden mehr als 5 Aktuatoren, mit größerem Vorzug mehr als 10 Aktuatoren, mit größerem Vorzug mehr als 20 Aktuatoren, mit größtem Vorzug mehr als 30 Aktuatoren, mit allergrößtem Vorzug mehr als 50 Aktuatoren, verwendet.

In einer weiteren erfindungsgemäßen Ausführungsform werden die Kontaktflächen der beiden Substrate in einer vertikalen Lage miteinander gebondet. Die Aufgabe dieser speziellen Ausführungsform besteht vor allem darin, die Verformung der Wafer durch die Gravitation zu reduzieren, mit Vorzug zumindest symmetrisch anzuordnen, mit besonderem Vorzug eine Verformung durch Gravitation ganz zu verhindern und/oder zu kompensieren. Mit Vorzug werden in der vertikalen Position beide Substrate, insbesondere gleichzeitig, symmetrisch zur Bondinitiierungsstelle durch je ein Stellmittel, insbesondere je einen Stift, zur Bondinitiierungsstelle hin gekrümmt, sodass die konvexen Oberflächen in der Bondinitiierungsstelle kontaktiert werden können. Der, insbesondere selbsttätige, Bondvorgang mit Bondwelle wird durch Loslösen mindestens eines der Substrate von der Aufnahmefläche gestartet.

Die erfindungsgemäßen Ausführungsformen werden mit Vorzug in einer definierten, insbesondere steuerbaren, Atmosphäre, insbesondere unter Normaldruck, betrieben.

Alle erwähnten erfindungsgemäßen Ausführungsformen können in einer speziellen Ausführungsvariante im Niedervakuum, mit größerem Vorzug im Hochvakuum, mit noch größerem Vorzug im Ultrahochvakuum durchgeführt, insbesondere bei einem Druck von weniger als 100 mbar, mit Vorzug weniger als 10⁻¹ mbar, mit größerem Vorzug weniger als 10⁻³ mbar, mit noch größerem Vorzug weniger als 10⁻⁵ mbar, mit allergrößtem Vorzug weniger als 10⁻⁸ mbar.

In einer weiteren erfindungsgemäßen Ausführungsform wird mindestens ein Einflussfaktor auf die Ausbreitung, insbesondere Ausbreitungsgeschwindigkeit, der Bondwelle und/oder mindestens ein Einflussfaktor auf die Ausrichtung der Kontaktflächen, gesteuert. Die Bondwelle wird insbesondere bezüglich Ihrer Geschwindigkeit kontrolliert. Die Steuerung der Geschwindigkeit erfolgt insbesondere indirekt über die Zusammensetzung und/oder die Dichte und/oder die Temperatur eines Gases in der Atmosphäre, in der gebondet wird. Obwohl das erfindungsgemäße Verfahren bevorzugt in einer Niederdruckatmosphäre, mit Vorzug im Vakuum durchgeführt werden soll, kann es vorteilhaft sein, den Bondprozess in einer anderen Atmosphäre, insbesondere im Bereich des Normaldrucks, durchzuführen. Durch den punktförmigen Kontakt läuft die Bondwelle beim erfindungsgemäßen Bonden immer radialsymmetrisch vom Zentrum zum Seitenrand und drückt bei diesem Vorgang ein ringförmiges Gaspolster vor sich her. Entlang der, insbesondere näherungsweise kreisringförmigen, Bondlinie (Bondfront) der Bondwelle herrscht eine derart große Bondkraft vor, dass Einschlüsse von Gasblasen gar nicht erst entstehen können. Das obere/zweite Substrat liegt daher während des Bondvorgangs auf einer Art Gaspolster.

Durch erfindungsgemäße Auswahl eines Gases/Gasgemisches und Definition der Eigenschaften des Gaspolsters wird festgelegt, wie schnell und wie stark sich das zweite Substrat absenken und/oder dehnen kann. Des Weiteren kann über die Eigenschaften des Gases auch die Geschwindigkeit der Bondwelle gesteuert werden.

Gemäß einem weiteren, insbesondere eigenständigen, Aspekt der Erfindung wird die Zusammensetzung des Gasgemisches gewählt. Mit Vorzug werden Gase mit möglichst leichten Atom- und/oder Molekülsorten verwendet, die bei gegebener Temperatur eine entsprechend geringe Trägheit besitzen. Daher ist die molare Masse mindestens einer der Gaskomponenten kleiner als 1000 g/mol, mit Vorzug kleiner als 100 g/mol, mit größerem Vorzug kleiner als 10 g/mol, mit allergrößtem Vorzug kleiner als 1 g/mol. Mit Weiteren Vorzug wird die Dichte des verwendeten Gasgemisches, insbesondere so gering wie möglich und/oder die Temperatur, insbesondere so hoch wie nötig, eingestellt. Die Gasdichte wird erfindungsgemäß kleiner als 10 kg/m³, mit Vorzug kleiner als 1 kg/m³, mit größerem Vorzug kleiner als 0.1 kg/m³, mit allergrößtem Vorzug größer als 0.01 kg/m³ eingestellt. Die Temperatur des Gases wird erfindungsgemäß größer als 0°C, mit Vorzug größer als 100°C, mit größerem Vorzug größer als 200°C, mit größtem Vorzug größer als 300°C, mit allergrößtem Vorzug größer als 400°C eingestellt. Erfindungsgemäß werden die vorgenannten Parameter so gewählt, dass das gewählte Gasgemisch bzw. einzelne Komponenten des Gasgemisches nicht kondensieren. Hierdurch werden Flüssigkeitseinschlüsse an der Oberfläche der Substrate während des Bondvorgangs vermieden.

Für Gasgemische, deren thermodynamische Eigenschaften in Mehrkomponentenpashendiagrammen dargestellt werden, gelten analoge Überlegungen. Durch die Änderung von Zusammensetzung und/oder Druck und/oder Temperatur des Gasgemisches wird die Kinematik des ersten und/oder zweiten Substrats beeinflusst und damit auch der "run-out" Fehler vermindert.

Mit besonderem Vorzug werden alle veränderbaren Parameter so gewählt, dass die Bondwelle sich mit einer möglichst optimalen Geschwindigkeit bezüglich der vorhandenen Anfangs- und Randbedingungen ausbreitet. Vor allem bei vorhandener Atmosphäre, insbesondere Normaldruck, ist eine möglichst langsame Geschwindigkeit der Bondwelle vorteilhaft. Die Geschwindigkeit der Bondwelle ist dabei geringer als 200 cm/s, mit größerem Vorzug gering er als 100 cm/s, mit größerem Vorzug geringer als 50 cm/s, mit größtem Vorzug geringer als 10 cm/s, mit allergrößtem Vorzug geringer als 1 cm/s. Insbesondere ist die Geschwindigkeit der Bondwelle größer als 0,1 cm/s. Insbesondere ist die Geschwindigkeit der Bondwelle entlang der Bondfront konstant. In einer Vakuumumgebung wird die Geschwindigkeit der Bondwelle automatisch schneller, da die sich entlang der Bondlinie verbindenden Substrate keinen Widerstand durch ein Gas überwinden müssen.

Gemäß einem weiteren, insbesondere eigenständigen, Erfindungsaspekt wird an der oberen/zweiten Aufnahmeeinrichtung eine Versteifungsplatte zwischen der Aufnahmefläche und dem oberen/zweiten Substrat eingefügt. Die Versteifungsplatte ist, insbesondere temporär, mit dem Substrat gebondet und ändert das Verhalten des oberen/zweiten Substrats beim Bonden. Die Verbindung zwischen der Versteifungsplatte und dem oberen/zweiten Substrat erfolgt durch eine konstruktionstechnische Fixierung in der Versteifungsplatte. Bei der Fixierung handelt es sich mit Vorzug um eine Vakuumfixierung. Denkbar wären auch elektrostatische Fixierungen, hauchdünne, die Substrate am Rand umspannende, mechanische Fixierungen, Adhäsionsfixierungen durch eine hochpolierte Versteifungsplattenoberfläche.

Gemäß einem weiteren, insbesondere eigenständigen, Erfindungsaspekt wird der "run-out" Fehler durch einen sehr geringen Abstand zwischen den beiden Substraten vor der Kontaktierung und/oder außerhalb der Bondinitiierungsstelle eingestellt. Der Abstand beträgt insbesondere weniger als 100µm, mit Vorzug weniger als 50µm, mit größerem Vorzug weniger als 20µm, mit allergrößtem Vorzug weniger als 10µm.

Erfindungsgemäß ist es besonders bevorzugt, wenn der Krümmungsradius beider Substrate, insbesondere an der Bondfront, um weniger als 5% voneinander abweicht, vorzugsweise gleich ist.

In einer weiteren speziellen Weiterbildung aller erfindungsgemäßen Ausführungsformen besitzen die untere/erste Aufnahmeeinrichtung und/oder die obere/zweite Aufnahmeeinrichtung als Stellmittel, insbesondere zentrische Bohrungen und einen Stift, mit deren Hilfe eine konvexe Krümmung der jeweiligen Substrate in Richtung der Bondinitiierungsstelle bewirkt werden kann.

Die Steuerung der vorbeschriebenen Schritte und/oder Bewegungen und/oder Abläufe, insbesondere der Stifte zur Durchbiegung der Substrate, die Annäherung der Substrate zueinander, die Temperatur-, Druck- und Gaszusammensetzungskontrolle, erfolgt mit Vorzug über eine zentrale Steuereinheit, insbesondere einen Computer mit einer Steuerungssoftware.

Die Aufnahme und Fixierung der Substrate auf Aufnahmeeinrichtungen kann auf jede erdenkliche Art mit jeder bekannten Technologie erfolgen. Erfindungsgemäß denkbar sind insbesondere Vakuumprobenhalter, elektrostatische Probenhalter, Probenhalter mit mechanischer Klemmung. Mit Vorzug werden die Substrate ausschließlich an einem möglichst weit außen liegenden Kreissegment im Bereich des Seitenrandes fixiert, um den Substraten weitestgehende Flexibilität und Dehnungsfreiheit innerhalb der Fixierung zu gewähren.

Ein weiterer, insbesondere eigenständiger, Erfindungsaspekt besteht darin, möglichst koordiniert und gleichzeitig quasi-selbsttätig zu kontaktieren, indem zumindest eines der Substrate mit einer, insbesondere konzentrisch zur Mitte M einer Kontaktfläche des Substrats radial nach außen verlaufenden, Vorspannung vor dem Kontaktieren beaufschlagt wird und dann nur der Beginn des Kontaktierens beeinflusst wird, während nach Kontaktierung eines Abschnitts, insbesondere der Mitte M des Substrats, das Substrat freigelassen wird und selbsttätig auf Grund seiner Vorspannung kontrolliert mit dem gegenüberliegenden Substrat bondet. Die Vorspannung wird durch eine Verformung des ersten Substrats mittels Verformungsmitteln erreicht, wobei die Verformungsmittel, insbesondere auf Grund ihrer Form, auf die von der Bondseite abgewandte Seite einwirken und die Verformung entsprechend durch Einsatz unterschiedlicher (insbesondere austauschbarer) Verformungsmittel steuerbar ist. Die Steuerung erfolgt auch durch den Druck oder die Kraft, mit der Die Verformungsmittel auf das Substrat wirken. Vorteilhaft ist es dabei, die wirksame Aufnahmefläche der Aufnahmeeinrichtung mit dem Halbleitersubstrat zu reduzieren, so dass das Halbleitersubstrat nur teilweise von der Aufnahmeeinrichtung gestützt wird. Auf diese Weise ergibt sich durch die kleinere Kontaktfläche eine geringere Adhäsion zwischen dem Wafer und dem Probenhalter beziehungsweise der Aufnahmeeinrichtung. Eine Fixierung wird erfindungsgemäß, insbesondere ausschließlich, im Bereich des Umfangs des Halbleitersubstrats (erstes Substrat) angelegt, so dass eine effektive Fixierung gegeben ist bei gleichzeitig geringst möglicher wirksamer Aufnahmefläche zwischen der Aufnahmekontur der Aufnahmeeinrichtung und dem Halbleitersubstrat. Somit ist gleichzeitig ein schonendes und sicheres Ablösen des Halbleitersubstrats möglich, da die zum Ablösen des Wafers notwendigen Lösekräfte so gering wie möglich sind. Das Ablösen ist vor allem kontrollierbar, insbesondere durch Reduzierung des Unterdrucks an der Aufnahmefläche. Kontrollierbar bedeutet, dass nach dem Kontakt des Wafers mit einem zweiten Wafer, der Wafer am Probenhalter noch fixiert bleibt und erst durch gezielte (gesteuerte) Reduzierung des Unterdrucks an der Aufnahmefläche ein Loslösen des Substrats (Wafers) vom Probenhalter (Aufnahmeeinrichtung), insbesondere von innen nach außen, bewirkt wird. Die erfindungsgemäße Ausführungsform führt vor allem dazu, dass das Ablösen durch sehr geringe Kräfte bewerkstelligt werden kann.

Die Substrate (Wafer) werden vor dem Bondvorgang zueinander ausgerichtet, um Deckungsgleichheit (exakte Ausrichtung, insbesondere mit einer Genauigkeit von weniger als 2µm, vorzugsweise weniger als 250nm, noch bevorzugter weniger als 150nm, am bevorzugtesten weniger als 100nm) korrespondierender Strukturen auf deren Oberflächen zu gewährleisten. Bei dem erfindungsgemäßen Bondverfahren werden die Wafer nicht plan aufeinander gelegt, sondern zunächst in der Mitte M miteinander in Kontakt gebracht, indem einer der beiden Wafer leicht gegen den zweiten Wafer gedrückt wird beziehungsweise entsprechend in Richtung des gegenüberliegenden Wafers verformt wird. Nach dem Loslösen des verformten (in Richtung des gegenüberliegenden Wafers) durchgebogenen Wafers erfolgt durch das Voranschreiten einer Bondwelle ein kontinuierliches und gleichmäßigeres, mit minimalster Kraft und damit mit minimalsten, vorwiegend horizontalen, Verzerrungen verbundenes, insbesondere zumindest überwiegend selbsttätiges, Verschweißen entlang der Bondfront.

Ein weiterer, insbesondere eigenständiger, Erfindungsaspekt besteht darin, die Verformung des ersten Substrats und/oder des zweiten Substrats abhängig von vorgegebenen Einflussfaktoren auf den Verlauf der Bondwelle zu steuern. Zu den Einflussfaktoren zählen unter anderem der Umgebungsdruck der die Substrate umgebenden Atmosphäre, die Art des in der Atmosphäre vorliegenden Gas/Gasgemisches, die Temperatur, der Abstand zwischen den Substraten außerhalb der Bondinitiierungsstelle, die Bondstärke der Substrate, etwaige Vorbehandlungsschritte, die Beschaffenheit der Oberflächen, die Oberflächenrauigkeit, die Materialien an der Oberfläche sowie Waferdicke/Biegesteifigkeit.

Soweit die Bondinitiierungsstelle im Zentrum der Kontaktflächen der Substrate angeordnet wird, ist ein gleichmäßiger, insbesondere konzentrischer Verlauf der Bondwelle realisierbar.

Besonders vorteilhaft ist es, wenn die Verformung des ersten Substrats und/oder des zweiten Substrats in lateraler Richtung und/oder konvex und/oder konkav erfolgt, noch bevorzugter Spiegelsymmetrisch. Mit anderen Worten folgt die Verformung erfindungsgemäß insbesondere durch Dehnung oder Stauchung oder Krümmung des ersten Substrats und/oder des zweiten Substrats.

Bevorzugt weisen die Substrate annähernd identische Durchmesser D1, D2 auf, die insbesondere um weniger als 5 mm, vorzugsweise weniger als 3 mm, noch bevorzugter weniger als 1 mm, voneinander abweichen.

Gemäß einem weiteren, insbesondere eigenständigen, Erfindungsaspekt erfolgt die Verformung durch mechanische Stellmittel und/oder durch Temperatursteuerung der ersten und/oder zweiten Aufnahmeeinrichtungen.

Indem das erste Substrat und/oder das zweite Substrat ausschließlich im Bereich der Seitenwände an den ersten und/oder zweiten Aufnahmeflächen fixiert wird, ist die erfindungsgemäße Verformung leichter realisierbar.

Vorrichtungsgemäß offenbarte Merkmale sollen auch als verfahrensgemäß offenbart gelten und umgekehrt.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Figur 1: eine schematische Querschnittsansicht einer ersten Ausführungsform der erfindungsgemäßen Vorrichtung,
- Figur 2: eine schematische Querschnittsansicht einer zweiten Ausführungsform der erfindungsgemäßen Vorrichtung,
- Figur 3: eine schematische Querschnittsansicht einer dritten Ausführungsform der erfindungsgemäßen Vorrichtung,
- Figur 4: eine schematische Querschnittsansicht einer vierten Ausführungsform der erfindungsgemäßen Vorrichtung,
- Figur 5: eine schematische Querschnittsansicht einer fünften Ausführungsform der erfindungsgemäßen Vorrichtung,
- Figur 6: eine schematische Darstellung des erfindungsgemäßen Verfahrensschritts des Bondens,
- Figur 7a: eine schematische Darstellung eines gebondeten Substratpaares mit einem Ausrichtungsfehler dx im Bereich eines Seitenrandes der Substrate,
- Figur 7b: eine schematische Vergrößerungsdarstellung zweier Substrate im Bereich einer erfindungsgemäßen Bondwelle,
- Figur 7c: eine schematischer Vergrößerungsdarstellung zweier Substrate ohne Ausrichtungsfehler/run-out-Fehler,
- Figur 7d: eine schematische Vergrößerungsdarstellung zweier Substrate mit Ausrichtungsfehler/run-out-Fehler und
- Figur 8: eine symbolische Darstellung der möglichen Overlay- bzw. "run-out" Fehler.

In den Figuren sind gleiche Bauteile und Bauteile mit der gleichen Funktion mit den gleichen Bezugszeichen gekennzeichnet.

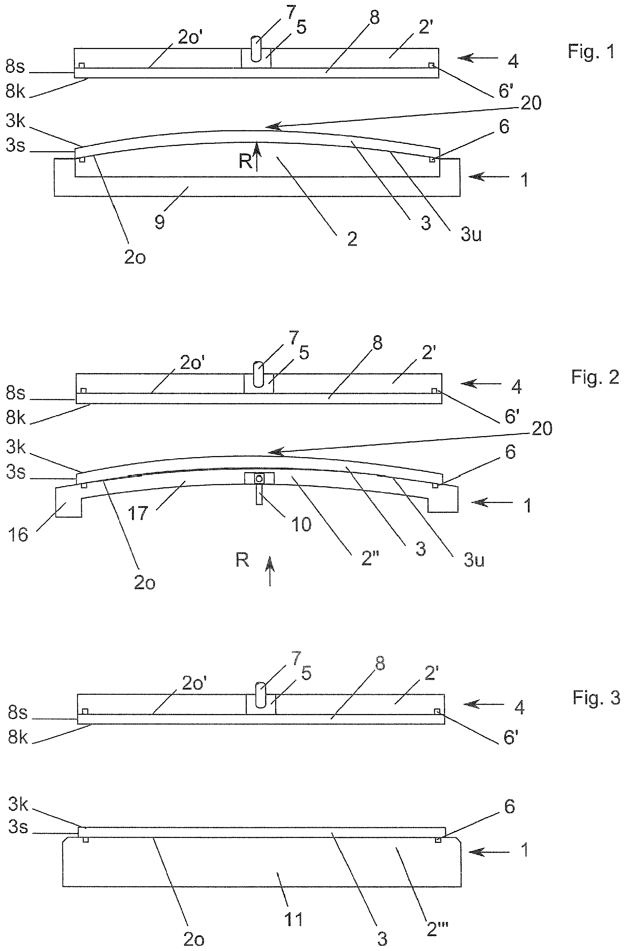

In Figur 1 ist eine untere erste Aufnahmeeinrichtung 1 als Substratprobenhalter gezeigt, die aus einem Grundkörper 9 und einem Aufnahmekörper 2 besteht. Der Aufnahmekörper 2 weist eine nach oben in Richtung einer gegenüberliegenden zweiten Aufnahmeeinrichtung 4 angeordnete erste Aufnahmefläche 2o auf, die im gezeigten Fall konvex gekrümmt ist. Der Aufnahmekörper 2 ist als Modul austauschbar ausgebildet und vom Grundkörper 9 trennbar. Der Grundkörper 9 dient somit als Adapter zwischen dem Aufnahmekörper 2 und einer unteren Aufnahmeeinheit des Bonders (nicht dargestellt). Dadurch wird es erfindungsgemäß möglich, bei Bedarf einen schnellen Wechsel zwischen verschiedenen, modulartigen Aufnahmekörpern 2 mit unterschiedlichen Krümmungsradien R durchzuführen.

An dem Aufnahmekörper 2 sind Fixiermittel 6 in Form von Vakuumbahnen angeordnet, mit welchen ein unteres, erstes Substrat 3 an der Aufnahmefläche 2o fixierbar ist.

Da der Krümmungsradius R erfindungsgemäß vorzugsweise sehr groß ist und somit die Krümmung mit dem Auge praktisch nicht erkennbar ist (die Darstellung in den Figuren ist stark übertrieben und schematisiert), ist es erfindungsgemäß denkbar, die erste Aufnahmeeinrichtung ohne Fixiermittel 6 auszuführen und das erste Substrat schließlich auf die Aufnahmefläche 2o zu legen. Erfindungsgemäß denkbar ist auch eine Adhäsion durch elektrostatische, elektrische oder magnetische Fixiermittel.

Die zweite, als Substratprobenhalter ausgebildete Aufnahmeeinrichtung 4 besteht aus einem Grundkörper 2' mit einer zweiten Aufnahmefläche 2o', die insbesondere in konzentrischen Abschnitten äquidistant zu entsprechenden konzentrischen Abschnitten der ersten Aufnahmefläche 2o ausrichtbar ist.

Der Grundkörper 2' weist eine Öffnung 5 in Form einer Bohrung und Fixiermittel 6' ähnlich den Fixiermitteln der ersten Aufnahmeeinrichtung 1 auf.

Die Fixiermittel 6' dienen zur Fixierung eines oberen, zweiten Substrats 8 an einer von der Kontaktfläche 8k des zweiten Substrats 8 abgewandten Seite.

Stellmittel in Form eines Stifts 7 dienen der Verformung (hier: Durchbiegung) und somit, vor allem der punktförmigen, Annäherung des zweiten Substrats 8 an das gekrümmte erste Substrat 3, insbesondere im Bereich eines Krümmungsmaximums.

In einer besonderen Ausführungsform ist es erfindungsgemäß denkbar, den Aufnahmekörper 2 als dehnbares, pneumatisch und/oder hydraulisch expandierbares und kontrahierbares Bauteil, insbesondere Kissen, insbesondere aus temperatur- und/oder korrosionsbeständigem Material, auszubilden.

Figur 2 zeigt eine zweite Ausführungsform mit einem Aufnahmekörper 2", bei dem die erste Aufnahmefläche 2o durch ein als Zug- und/oder Druckstange ausgebildetes Stellelement 10 kontrolliert verformbar ist. Die Aufnahme 2" weist einen, insbesondere konzentrisch umlaufenden, Fixierabschnitt 16 und einen für die erste Aufnahmefläche 2o umfassenden Verformungsabschnitt 17 auf. Der Verformungsabschnitt 17 weist zumindest überwiegend eine konstante Dicke und somit eine überwiegend konstante Biegesteifigkeit auf. Das Stellelement 10 ist an der zur ersten Aufnahmefläche 2o abgewandten Stellseite des Verformungsabschnitts 17 angeordnet, insbesondere fixiert. Mittels des Stellelements 10 ist der Verformungsabschnitt 17 im Mikrometerbereich verformbar, insbesondere konvex und konkav krümmbar. Das Stellelement 10 verfährt dabei mehr als 0.01 µm, mit Vorzug mehr als +/- 1µm, mit größerem Vorzug mehr als +/-1µm, mit größtem Vorzug mehr als +/- 100µm, mit allergrößtem Vorzug mehr als +/- 1mm, am bevorzugtesten mehr als +/- 10mm. Im Übrigen entspricht die Ausführungsform gemäß Figur 2 der Ausführungsform gemäß Figur 1.

Figur 3 zeigt eine dritte Ausführungsform mit einer ersten Aufnahmeeinrichtung 1 mit einem Aufnahmekörper 2'''. Der Aufnahmekörper 2''' weist die erste Aufnahmefläche 2o zur Aufnahme des ersten Substrats 3 auf. Weiterhin umfasst die erste Aufnahmeeinrichtung 1 bei dieser Ausführungsform Temperatursteuerungsmittel 11 zur Temperatursteuerung (Heizung und/oder Kühlung) des Aufnahmekörpers 2''' zumindest im Bereich der ersten Aufnahmefläche 2o, vorzugsweise des gesamten Aufnahmekörpers 2'''.

In der ersten Vorgehensweise wird das erste Substrat 3 auf dem geheizten Aufnahmekörper 2''' erst nach Erreichen seiner durch die Temperaturdifferenz hervorgerufenen Dehnung fixiert. Dadurch dehnt sich das erste Substrat 3 entsprechend seines eigenen thermischen Ausdehnungskoeffizienten.

In einer zweiten Vorgehensweise wird das erste Substrat 3 auf dem Aufnahmekörper 2''' vor der thermischen Belastung durch die Temperatursteuerungsmittel 11 fixiert. Durch Änderung der Temperatursteuerungsmittel 11 dehnt sich der Aufnahmekörper 2''' und somit die erste Aufnahmefläche 2o mit dem daran fixierten ersten Substrat 3, insbesondere in lateraler Richtung aus. Vorzugsweise besitzt der Aufnahmekörper 2''' im Wesentlichen denselben thermischen Ausdehnungskoeffizienten wie das erste Substrat 3. Im Übrigen entspricht die dritte Ausführungsform den vorbeschriebenen ersten und zweiten Ausführungsformen.

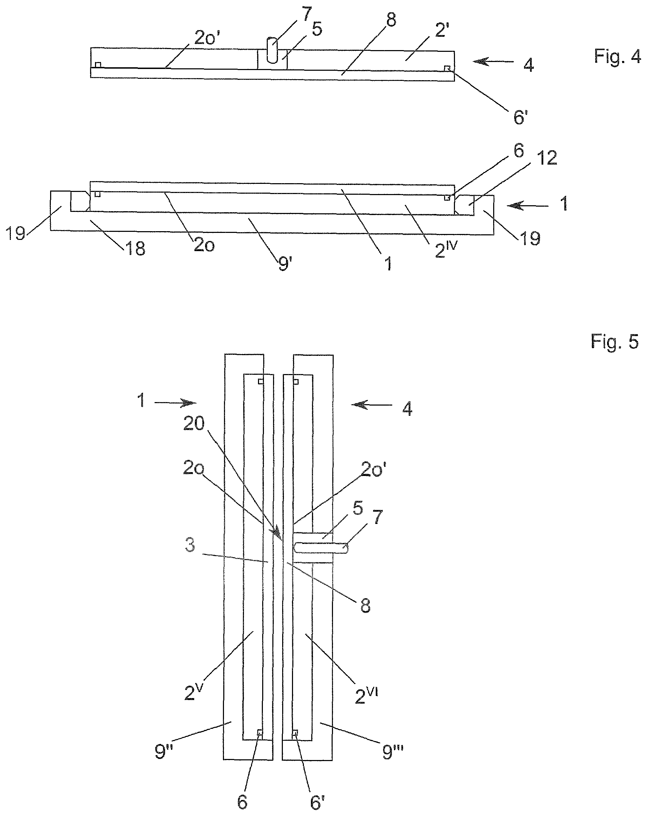

Figur 4 zeigt eine vierte Ausführungsform mit einem Grundkörper 9' mit einem Aufnahmeabschnitt 18 zur Aufnahme eines Aufnahmekörpers 2^{IV}. Weiterhin umfasst der Grundkörper 9' an den Aufnahmeabschnitt 18 anschließende, insbesondere umlaufend ausgebildeten, Schulterabschnitt 19 auf. Der Schulterabschnitt 19 dient als Anschlag für Stellelemente 12, die zur Verformung des Aufnahmekörpers 2^{IV} in lateraler Richtung dienen. Die Stellelemente 12 sind insbesondere in Form einer Vielzahl von Zug- und/oder Druckelementen 12 am Seitenumfang des Aufnahmekörpers 2^{IV} verteilt angeordnet. Die Stellelemente 12 dienen zur Verformung des Aufnahmekörpers 2^{IV} in lateraler Richtung, insbesondere durch mechanische Dehnung und/oder Stauchung, vorzugsweise im Mikrometerbereich. Der Aufnahmekörper 2^{IV} dehnt/staucht sich dabei um mehr als 0.01 µm, mit Vorzug mehr als +/- 1µm, mit größerem Vorzug mehr als +/- 1µm, mit größtem Vorzug mehr als +/- 100µm, mit allergrößtem Vorzug mehr als +/-1mm, am bevorzugtesten mehr als +/- 10mm. Die Stellelemente 12 können als rein mechanische und/oder pneumatische und/oder hydraulische und/oder piezoelektrische Bauteile ausgeführt sein.

Im Übrigen entspricht die vierte Ausführungsform den vorbeschriebenen ersten, zweiten und dritten Ausführungsformen. In der vierten Ausführungsform ist es besonders wichtig, dass die Adhäsion zwischen dem Substrat 1 und dem Aufnahmekörper 2^{IV} so groß ist, dass das Substrat 1 während der Streckung oder Stauchung des Aufnahmekörpers 2^{IV} durch die Stellelemente 12, ebenfalls entsprechend gestreckt bzw. gestaucht wird.

Figur 5 zeigt eine fünfte Ausführungsform, bei der die erste Aufnahmeeinrichtung 1 und die zweite Aufnahmeeinrichtung 4 vertikal ausgerichtet ist. Die erste Aufnahmeeinrichtung 1 weist einen Grundkörper 9" und einen von dem Grundkörper 9" fixierten Aufnahmekörper 2^{V} auf. Der Aufnahmekörper 2^{V} umfasst die bei dieser Ausführungsform vertikal angeordnete erste Aufnahmefläche 2o auf, an der das erste Substrat 3 über Fixierelemente 6 fixiert ist.

Die zweite Aufnahmeeinrichtung 4 umfasst einen gegenüberliegend angeordneten Grundkörper 9'" zur Aufnahme und Fixierung eines Aufnahmekörpers 2^{VI}. Der Aufnahmekörper 2^{VI} dient zur Aufnahme und Fixierung des zweiten Substrats 8 an seiner vertikal angeordneten Aufnahmefläche 2o'. Zur Verformung des zweiten Substrats 8 ist eine Öffnung 5 analog der Öffnung 5 gemäß Figur 1 mit einem Stellmittel in Form eines Stifts 7 vorgesehen, der durch die Öffnung 5 hindurch das zweite Substrat 8 verformend ausgebildet ist, und zwar an einer von der Kontaktfläche 8k des zweiten Substrats 8 abgewandten Seite. Der Stift 7 definiert durch Verformung des zweiten Substrats 8 eine Bondinitiierungsstelle 20 bei Kontaktierung der Substrate 3, 8.

Abgesehen von der Öffnung 5 und dem Stift 7 sind die erste Aufnahmeeinrichtung 1 und die zweite Aufnahmeeinrichtung 4 bei der Ausführungsform gemäß Figur 5 symmetrisch ausgebildet. Bevorzugt weist auch die erste Aufnahmeeinrichtung eine entsprechende Öffnung und einen entsprechenden Stift auf, so dass eine symmetrische Verformung der Substrate 3, 8 ermöglicht wird. Durch gleichzeitiges Lösen der Fixiermittel 6, 6' nach Kontaktierung der verformten Substrate 3, 8 an einer, insbesondere im Zentrum der Substrate 3, 8 angeordneten, Bondinitiierungsstelle 20 verhalten sich die Substrate 3, 8 identisch, so dass auch mangels eines Einflusses einer Gravitationskraft auf die Verformung in Richtung der Kontaktflächen 3k, 8k aufeinander zu keine Ausrichtungsfehler während des Voranschreitens der Bondwelle auftreten. Dies gilt insbesondere bei Identität der überwiegenden Zahl der erfindungsgemäßen Einflussfaktoren auf die Bondwelle beziehungsweise Ausrichtungsfehler, insbesondere der Dicke der Substrate beziehungsweise der Biegesteifigkeit der Substrate. Die Biegesteifigkeit ist der Widerstand, den ein Körper einer ihm aufgezwungenen Biegung entgegensetzt. Je höher die Biegesteifigkeit, desto größer muss das Biegemoment sein, um die gleiche Krümmung zu erzielen. Die Biegesteifigkeit ist eine reine Material- und Geometriegröße, die unabhängig vom Biegemoment ist (unter der Annahme, dass das Biegemoment das Trägheitsmoment durch eine Querschnittsänderung nicht verändert). Der Querschnitt eines Wafers durch sein Zentrum ist in sehr guter Näherung ein Rechteck mit einer Dicke t3, und dem Waferdurchmesser D. Die Biegesteifigkeit ist für homogene Querschnitte das Produkt aus E-Modul und Flächenträgheitsmoment. Das Flächenträgheitsmoment eines Rechtecks um eine Achse normal zur Dicke wäre direkt proportional zur dritten Potenz der Dicke. Durch die Dicke wird also das Trägheitsmoment und damit das Biegemoment beeinflusst. Das Biegemoment entsteht durch die Einwirkung der Gravitationskraft entlang des Substrats. Bei konstantem Biegemoment, daher konstanter Gravitationskraft, werden also Substrate mit größeren Dicken auf Grund ihrer größeren Biegemomente weniger gekrümmt als Substrate mit geringeren Dicken.

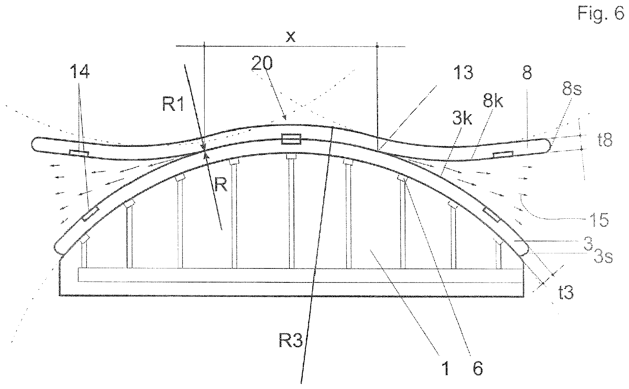

In Figur 6 ist der Bondvorgang schematisch dargestellt, wobei ein Krümmungsradius R der ersten Aufnahmeeinrichtung 1 zur Veranschaulichung stark übertrieben dargestellt ist. Der Krümmungsradius beträgt erfindungsgemäß mehrere Meter bei Durchmessern der Substrate 3, 8 im Bereich von 1 Zoll bis 18 Zoll und Dicken der Substrate 3, 8 im Bereich von 1 µm bis 2.000 µm.

Nach Kontaktierung der Substrate 3, 8 an Kontaktflächen 3k, 8k im Bereich der im Zentrum der Substrate 3, 8 liegenden Bondinitiierungsstelle 20 und Aufheben der Fixierung (Loslösen) des zweiten Substrats 8 von der zweiten Aufnahmeeinrichtung 4 beginnt das Bonden. Eine Bondwelle mit einer Bondfront 10 verläuft konzentrisch von der Bondinitiierungsstelle 20 bis zu Seitenrändern 8s, 3s der Substrate 3, 8.

Dabei verdrängt die Bondwelle das zwischen den Kontaktflächen 3k, 8k durch Pfeile dargestellte Gas 15 (oder Gasmischung 15).

Erfindungsgemäß wird das Substrat 3 durch die Aufnahmeeinrichtung 1 so verformt, dass Ausrichtungsfehler von korrespondierenden Strukturen 14 der Substrate 3, 8 minimiert werden.

Das Substrat 8 verformt sich während des Laufs der Bondwelle (nach der Bondiniitierung und Loslassen von der Aufnahmeeinrichtung 4) aufgrund der wirkenden Kräfte: Gasdruck, Gasdichte, Geschwindigkeit der Bondwelle, Schwerkraft, Eigenfrequenz (Federverhalten) des Substrats 8.

Im gezeigten Ausführungsbeispiel, das insbesondere den ersten beiden Ausführungsformen gemäß Figuren 1 und 2 entspricht, erfolgt die Verformung durch Krümmung der Substrate 3, 8, wobei ein Krümmungsradius R des oberen Substrats 8, insbesondere zu jedem Zeitpunkt an der Bondfront 13, dem Krümmungsradius R1 des unteren Substrats 3 im Wesentlichen entspricht. Ist eine der beiden Aufnahmeflächen 2o, 2o' eben, und damit auch der Radius des entsprechenden, auf der ebenen Aufnahmefläche 2o oder 2o' gelagerten, Substrats 3 oder 8 unendlich groß, so wird auch der Radius des entsprechend gegenüberliegenden Substrats 8 oder 3 entsprechend groß eingestellt, im Grenzfall unendlich groß. Es wird somit auch eine erfindungsgemäße Kompensation des "run-out" Fehlers durch eine Annäherung zweier Substrate 3 und 8, deren Krümmungsradien unendlich groß sind, daher deren Kontaktflächen 3k, 8k parallel zueinander sind, offenbart. Dieser erfindungsgemäße Spezialfall würde sich vor allem in einer Vakuumumgebung eignen, um die beiden Substrate 3 und 8 miteinander zu verbinden, da es nicht nötig wäre, die beiden Substrate 3 und 8 durch eine, sich vom Bondzentrum ausbreitende, eine Gasmenge aus dem Bondinterface vor sich herschiebende, Bondwelle miteinander zu bonden. Die Differenz der Krümmungsradien R1 und R ist erfindungsgemäß insbesondere kleiner als 100 m, mit Vorzug kleiner als 10 m, mit größerem Vorzug kleiner als 1 m, mit größtem Vorzug kleiner als 1 cm, mit allergrößtem Vorzug kleiner als 1 mm.

Dabei ist es erfindungsgemäß denkbar, die Atmosphäre durch Wahl des Gases 15 beziehungsweise der Gasmischung 15 sowie des Drucks und/oder der Temperatur die Bondgeschwindigkeit zu steuern.

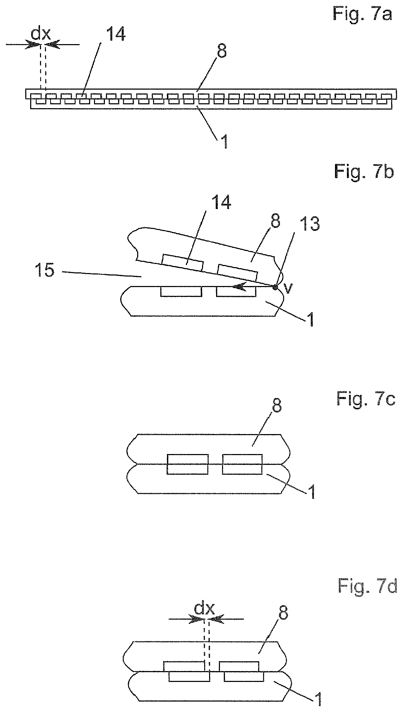

Die Figuren 7a bis 7d veranschaulichen in vergrößerter Form etwaige Ausrichtungsfehler dx gemäß Figuren 7a und 7d, die erfindungsgemäß gemäß Figuren 7b und 7c durch die Verformung der Substrate 3, 8 zumindest überwiegend behoben werden.

Die beschriebenen Verfahrensschritte, insbesondere Bewegungen und Parameter werden durch eine, insbesondere softwaregestützte, Steuerungseinrichtung (nicht dargestellt) gesteuert.

### Bezugszeichenliste

- 1: Erste Aufnahmeeinrichtung
- 2, 2', 2", 2''', 2^{IV}, 2^{V}, 2^{VI}: Aufnahmekörper
- 2o: Erste Aufnahmefläche
- 2o': Zweite Aufnahmefläche
- 3: Erstes Substrat
- 3k: Erste Kontaktfläche
- 3s: Seitenrand
- 4: Zweite Aufnahmeeinrichtung
- 5: Öffnung
- 6, 6': Fixiermittel
- 7: Stift
- 8: zweites Substrat
- 8k: zweite Kontaktfläche
- 8s: Seitenrand
- 9, 9', 9", 9''': Grundkörper
- 10: Stellelement
- 11: Temperatursteuerungsmittel
- 12: Stellelement
- 13: Bondfront
- 14, 14': Struktur
- 15: Gas/Gasmischung
- 16: Fixierabschnitt
- 17: Verformungsabschnitt
- 18: Aufnahmeabschnitt
- 19: Schulterabschnitt
- 20: Bondinitiierungsstelle
- dx: Ausrichtungsfehler
- dl, d2: Durchmesser
- R, R1: Krümmungsradius

## Patentansprüche

1. Verfahren zum Bonden eines ersten Substrats (3) mit einem zweiten Substrat (8) an Kontaktflächen (3k, 8k) der Substrate (3, 8) mit folgenden Schritten, insbesondere folgendem Ablauf:
- Aufnahme des ersten Substrats (3) an einer ersten Aufnahmefläche (2o) einer ersten Aufnahmeeinrichtung (1) und Aufnahme des zweiten Substrats (8) an einer zweiten Aufnahmefläche (2o') einer zweiten Aufnahmeeinrichtung (4),
- Kontaktierung der Kontaktflächen (3k, 8k) an einer Bondinitiierungsstelle (20),
- Bonden des ersten Substrats (3) mit dem zweiten Substrat (8) entlang einer von der Bondinitiierungsstelle (20) zu Seitenrändern (3s, 8s) der Substrate (3, 8) verlaufenden Bondwelle,
**dadurch gekennzeichnet, dass**
das erste Substrat (3) und/oder das zweite Substrat (8) zur Ausrichtung der Kontaktflächen (3k, 8k) außerhalb der Bondinitiierungsstelle (20) vor und/oder während des Bondens verformt sind/werden,
wobei die zweite Aufnahmeeinrichtung (4) eine Öffnung aufweist, und
wobei die Öffnung mit einer Düse versehen ist zur Verformung des zweiten Substrats (8) durch Druckbeaufschlagung zur Ausrichtung der Kontaktflächen (3k, 8k).

2. Verfahren gemäß Anspruch 1, bei dem die Verformung des ersten Substrats (3) und/oder des zweiten Substrats (8) abhängig von vorgegebenen Einflussfaktoren auf den Verlauf der Bondwelle erfolgt.

3. Verfahren nach einem der vorhergehenden Ansprüche, bei dem die Bondinitiierungsstelle (20) im Zentrum der Kontaktflächen (3k, 8k) angeordnet ist.

4. Verfahren nach einem der vorhergehenden Ansprüche, bei dem die Verformung des ersten Substrats (3) und/oder des zweiten Substrats (8) in lateraler Richtung und/oder konvex oder konkav erfolgt.

5. Verfahren nach einem der vorhergehenden Ansprüche, bei dem die Verformung durch Dehnung oder Stauchung oder Krümmung des ersten Substrats (3) und/oder des zweiten Substrats (8) erfolgt.

6. Verfahren nach einem der vorhergehenden Ansprüche, bei dem Durchmesser (d1, d2) der Substrate (3, 8) um weniger als 5mm, insbesondere weniger als 3mm, vorzugsweise weniger als 1mm, voneinander abweichen.

7. Verfahren nach einem der vorhergehenden Ansprüche, bei dem die Verformung durch mechanische Stellmittel und/oder durch Temperatursteuerung der ersten und/oder zweiten Aufnahmeeinrichtungen (1, 4) erfolgt.

8. Verfahren nach einem der vorhergehenden Ansprüche, bei dem das erste Substrat (3) und/oder das zweite Substrat (8) ausschließlich im Bereich der Seitenränder (3s, 8s) an den ersten und/oder zweiten Aufnahmeflächen (2o, 2o') fixiert werden.

9. Vorrichtung zum Bonden eines ersten Substrats (3) mit einem zweiten Substrat (8) an Kontaktflächen (3k, 8k) der Substrate (3, 8) mit:
- einer ersten Aufnahmeeinrichtung (1) zur Aufnahme des ersten Substrats (3) an einer ersten Aufnahmefläche (2o) und einer zweiten Aufnahmeeinrichtung (4) zur Aufnahme des zweiten Substrats (8) an einer zweiten Aufnahmefläche (2o'),
- Kontaktmitteln zur Kontaktierung der Kontaktflächen (3k, 8k) an einer Bondinitiierungsstelle (20),
und mit
Verformungsmitteln zur Verformung des ersten Substrats (3) und/oder des zweiten Substrats (8) zur Ausrichtung der Kontaktflächen (3k, 8k) außerhalb der Bondinitiierungsstelle (20) vor und/oder während des Bondens,
wobei die zweite Aufnahmeeinrichtung (4) eine Öffnung aufweist, und
wobei die Öffnung mit einer Düse versehen ist zur Verformung des zweiten Substrats (8) durch Druckbeaufschlagung zur Ausrichtung der Kontaktflächen (3k, 8k).

10. Vorrichtung nach Anspruch 9, bei der die Verformungsmittel die, insbesondere an der ersten Aufnahmefläche (2o) in lateraler Richtung und/oder konvex oder konkav verformbare, erste Aufnahmeeinrichtung (1) umfassen.

11. Vorrichtung nach Anspruch 9, bei der die Verformungsmittel die, insbesondere an der zweiten Aufnahmefläche (2o') in lateraler Richtung und/oder konvex oder konkav verformbare, zweite Aufnahmeeinrichtung (4) umfassen.

12. Vorrichtung nach wenigstens einem Ansprüche 9 bis 11, bei der die Verformungsmittel mechanische Stellmittel und/oder Temperatursteuerungsmittel zur Steuerung der Temperatur der ersten und/oder zweiten Aufnahmeeinrichtungen (1, 4) aufweisen.

13. Vorrichtung nach wenigstens einem Ansprüche 9 bis 12, bei der Fixiermittel zur Fixierung des ersten Substrats (3) und/oder des zweiten Substrats (8) ausschließlich im Bereich der Seitenränder (3s, 8s) an den ersten und/oder zweiten Aufnahmeflächen (2o, 2o') angeordnet sind.
